# EUROPEAN PATENT APPLICATION

(11) **EP 4 376 103 A1**
(43) Date of publication of application: **29.05.2024**
(21) Application number: 22859933.8
(22) Date of filing: 12.05.2022
(51) Int. Cl.: H01L 31/18, H01L 31/05

(54) **SOLAR CELL SHEET, SOLAR CELL SLICE AND PHOTOVOLTAIC ASSEMBLY**

(30) Priority: 25.08.2021 CN 202122018861 U
(71) Applicant: Longi Solar Technology (Taizhou) Co., Ltd., Taizhou, Jiangsu 225300 (CN)
(72) Inventor: ZHAO, Debao, Taizhou, Jiangsu 225300 (CN); CHEN, Jun, Taizhou, Jiangsu 225300 (CN); LI, Hua, Taizhou, Jiangsu 225300 (CN); LIU, Jiyu, Taizhou, Jiangsu 225300 (CN)
(74) Representative: Manitz Finsterwald Patent- und Rechtsanwaltspartnerschaft mbB
(86) International application number: PCT/CN2022/092491
(87) International publication number: WO 2023/024585

(57) **Abstract**

The present disclosure provides a solar cell sheet, a solar cell slice, and a photovoltaic assembly. The solar cell sheet includes: a semiconductor substrate, and a positive electrode and a negative electrode that are arranged on a shadow surface of the semiconductor substrate; the semiconductor substrate comprises a first substrate portion and a second substrate portion that are symmetrically arranged along a central line of the semiconductor substrate. In the present disclosure, the solar cell sheet is cut along the central line to obtain two slices. As the two slices respectively correspond to the first substrate portion and the second substrate portion, the extension directions of the first positive electrode portion and the second negative electrode portion coincide and can be connected to both ends of the conductive wire, respectively. The extension directions of the first negative electrode portion and the second positive electrode portion coincide, which can be connected to the both ends of another conductive wire, respectively. So, the two slices can be directly connected in series through the conductive wire after cutting, without the need to rotate one of the slices or align them, thereby simplifying the process operation steps and improving the production efficiency and yield of the photovoltaic assembly.

## Description

The present disclosure claims the priority of the Chinese patent application filed on August 25th 2021 before the China National Intellectual Property Administration with the application number of 202122018861.0 and the title of "solar cell sheet, solar cell slice and photovoltaic assembly", which is incorporated herein in its entirety by reference.

### TECHNICAL FIELD

The present disclosure relates to the technical field of photovoltaic and more particularly, to a solar cell sheet, a solar cell slice and a photovoltaic assembly.

### BACKGROUND

Interdigitated back contact (IBC) solar cells refer to solar cells with no electrode on the front surface of the cell, and both positive and negative electrodes are set on the back surface of the cell, which can reduce the obstruction of the electrodes on the cell, increase the short-circuit current of the cell, and improve the energy conversion efficiency of the cell.

In existing back contact solar cells, the entire back surface of the solar cell can include a plurality of positive main gate electrodes and negative main gate electrodes that are parallel and spaced. In the process of assembling a plurality of solar cells into a photovoltaic assembly, the entire solar cell needs to be cut into half cells along a direction perpendicular to the positive main gate electrodes and negative main gate electrodes, and then one half cell needs to be rotated 180 degrees, and the two adjacent half cells are aligned, so that, for the two adjacent half cells, an extension direction of the positive main gate electrodes in one half cell and that of the negative main gate electrodes in the other half cell coincide. Thus, it can use welding strips to conduct the positive main gate electrodes and the negative main gate electrodes in the two adjacent half cells, and then connect the two adjacent half cells to obtain the photovoltaic assembly.

However, in prior art, when the welding strips are used to connect the two adjacent half cells, it is required to rotate one half cell 180 degrees, and at the same time, it is required to align the corresponding positive main gate electrode and negative main gate electrode in the two adjacent two half cells, which leads to a complex process and cumbersome steps in the preparation of photovoltaic assemblies, thereby reducing their production efficiency.

### SUMMARY

The present disclosure provides a solar cell sheet, a solar cell slice, and a photovoltaic assembly to solve the problem of low production efficiency caused by the complex process and cumbersome steps of the preparation of the photovoltaic assembly in the prior art.

In a first aspect, the present disclosure provides a solar cell sheet, and the solar cell sheet includes:
a semiconductor substrate, and a positive electrode and a negative electrode that are arranged on a shadow surface of the semiconductor substrate;
the semiconductor substrate includes a first substrate portion and a second substrate portion that are symmetrically arranged along a central line of the semiconductor substrate;
the positive electrode includes a first positive electrode portion arranged in the first substrate portion and a second positive electrode portion arranged in the second substrate portion, the negative electrode includes a first negative electrode portion arranged in the first substrate portion and a second negative electrode portion arranged in the second substrate portion;
the first positive electrode portion and the first negative electrode portion are arranged in parallel in the first substrate portion, the second positive electrode portion and the second negative electrode portion are arranged in parallel in the second substrate portion; and
in the first substrate portion and the second substrate portion, an extension direction of the first positive electrode portion and an extension direction of the second negative electrode portion coincide, and an extension direction of the first negative electrode portion and an extension direction of the second positive electrode portion coincide.

Optionally, the first positive electrode portion includes a plurality of first positive-electrode connection points for connecting to a conductive wire, and first positive-electrode connection grid lines connecting adjacent first positive-electrode connection points; the first negative electrode portion includes a plurality of first negative-electrode connection points for connecting to the conductive wire, and first negative-electrode connection grid lines connecting adjacent first negative-electrode connection points; and
the second positive electrode portion includes a plurality of second positive-electrode connection points for connecting to the conductive wire, and second positive-electrode connection grid lines connecting adjacent second positive-electrode connection points; the second negative electrode portion includes a plurality of second negative-electrode connection points for connecting to the conductive wire, and second negative-electrode connection grid lines connecting adjacent second negative-electrode connection points.

Optionally, the positive electrode further includes a first positive-electrode fine grid portion arranged in the first substrate portion and a second positive-electrode fine grid portion arranged in the second substrate portion; the negative electrode further includes a first negative-electrode fine grid portion arranged in the first substrate portion and a second negative-electrode fine grid portion arranged in the second substrate portion;
the first positive-electrode fine grid portion and the first negative-electrode fine grid portion are parallel and spaced apart from each other, one end of the first positive-electrode fine grid portion is connected to the first positive electrode portion, the other end of the first positive-electrode fine grid portion is separated by a first preset distance from the first negative electrode portion; one end of the first negative-electrode fine grid portion is connected to the first negative electrode portion, and the other end of the first negative-electrode fine grid portion is separated by a second preset distance from the first positive electrode portion; and
the second positive-electrode fine grid portion and the second negative-electrode fine grid portion are parallel and spaced apart from each other, one end of the second positive-electrode fine grid portion is connected to the second positive electrode portion, the other end of the second positive-electrode fine grid portion is separated by a third preset distance from the second negative electrode portion, one end of the second negative-electrode fine grid portion is connected to the second negative electrode portion, and the other end of the second negative-electrode fine grid portion is separated by a fourth preset distance from the second positive electrode portion.

Optionally, the solar cell sheet further includes: an insulation layer;
the insulation layer is arranged between adjacent first positive-electrode connection points, and covers a part of the first negative-electrode fine grid portion close to the first positive-electrode connection grid line and between adjacent first positive-electrode connection points; or
the insulation layer is arranged between adjacent second positive-electrode connection points, and covers a part of the second negative-electrode fine grid portion close to the second positive-electrode connection grid line and between adjacent second positive-electrode connection points; or
the insulation layer is arranged between adjacent first negative-electrode connection points, and covers a part of the first positive-electrode fine grid portion close to the first negative-electrode connection grid line and between adjacent first negative-electrode connection points; or
the insulation layer is arranged between adjacent second negative-electrode connection points, and covers a part of the second positive-electrode fine grid portion close to the second negative-electrode connection grid line and between adjacent second negative-electrode connection points.

Optionally, structures of the first positive-electrode connection points, the first negative-electrode connection points, the second positive-electrode connection points and the second negative-electrode connection points are square structures, side lengths of the square structures are 600-1500 millimeters;
widths of the first positive-electrode connection grid lines, the first negative-electrode connection grid lines, the second positive-electrode connection grid lines and the second negative-electrode connection grid lines are 150-400 millimeters;
widths of the first positive-electrode fine grid portion and the second positive-electrode fine grid portion are 60-200 millimeters; and
widths of the first negative-electrode fine grid portion and the second negative-electrode fine grid portion are 20-60 millimeters.

Optionally, each of the first positive-electrode connection points and the second positive-electrode connection points includes a central portion and an outer edge portion arranged at an outer side of the central portion;
a structure of the central portion is a square structure, side lengths of the central portion are 600-1200 millimeters;
an inner contour of the outer edge portion and an outer contour of the central portion overlap with each other, an outer contour of the outer edge portion and the inner contour are parallel to each other, and side lengths of the outer contour of the outer edge portion are 800-1600 millimeters.

Optionally, the central portion is a silver electrode, and the outer edge portion is an aluminum electrode.

In a second aspect, the present disclosure provides a solar cell slice, and the solar cell slice includes: a first slice and a second slice that are obtained by cutting the above solar cell sheet along the central line of the semiconductor substrate;
the semiconductor substrate includes the first substrate portion and the second substrate portion that are symmetrically arranged along the central line of the semiconductor substrate;
the first slice includes the first substrate portion, and the first positive electrode portion and the first negative electrode portion that are arranged in the first substrate portion, the first positive electrode portion and the first negative electrode portion are arranged in parallel;
the second slice includes the second substrate portion, and the second positive electrode portion and the second negative electrode portion that are arranged in the second substrate portion, the second positive electrode portion and the second negative electrode portion are arranged in parallel; and
in the first slice and the second slice, the extension direction of the first positive electrode portion and the extension direction of the second negative electrode portion coincide, the extension direction of the first negative electrode portion and the extension direction of the second positive electrode portion coincide.

In a third aspect, the present disclosure provides a photovoltaic assembly, and the photovoltaic assembly includes a plurality of solar cell slices described above and a plurality of conductive wires;
a first slice and a second slice of the plurality of solar cell slices are separated;
one end of one conductive wire is connected to the first positive electrode portion of the first slice, the other end of the conductive wire is connected to the second negative electrode portion of adjacent second slice; one end of another conductive wire is connected to the first negative electrode portion of the first slice, and the other end of the another conductive wire is connected to the second positive electrode portion of adjacent second slice.

Optionally, the photovoltaic assembly further includes a connecting part;
the connecting part is arranged between the first slice and the second slice that are adjacent, the connecting part extends along the central line of the semiconductor substrate, and is electrically connected to the conductive wire connecting the first slice and the second slice that are adj acent.

In the solar cell sheet, the solar cell slice, and the photovoltaic assembly provided by the embodiments of the present disclosure, the solar cell sheet includes: a semiconductor substrate, and a positive electrode and a negative electrode that are arranged on a shadow surface of the semiconductor substrate; the semiconductor substrate includes a first substrate portion and a second substrate portion that are symmetrically arranged along a central line of the semiconductor substrate; the positive electrode includes a first positive electrode portion arranged in the first substrate portion and a second positive electrode portion arranged in the second substrate portion, the negative electrode includes a first negative electrode portion arranged in the first substrate portion and a second negative electrode portion arranged in the second substrate portion; the first positive electrode portion and the first negative electrode portion are arranged in parallel in the first substrate portion, the second positive electrode portion and the second negative electrode portion are arranged in parallel in the second substrate portion; and in the first substrate portion and the second substrate portion, an extension direction of the first positive electrode portion and an extension direction of the second negative electrode portion coincide, and an extension direction of the first negative electrode portion and an extension direction of the second positive electrode portion coincide. In the present disclosure, two slices can be obtained by cutting the solar cell sheet along the central line, since in the first substrate portion and the second substrate portion corresponding to the two slices respectively, the extension directions of the first positive electrode portion and the second negative electrode portion coincide the first positive electrode portion and the second negative electrode portion can be connected to both ends of the conductive wire respectively. Since the extension directions of the first negative electrode portion and the second positive electrode portion coincide, the first negative electrode portion and the second positive electrode portion can be connected to both ends of another conductive wire. The two slices can be directly connected in series through the conductive wires after cutting, without the need to rotate one of them or align them, thus simplifying the process operation steps and improving the production efficiency and yield of the photovoltaic assembly.

### BRIEF DESCRIPTION OF THE DRAWINGS

In order to more clearly illustrate the technical solutions of the embodiments of the present disclosure, the figures that are required to describe the embodiments of the present disclosure will be briefly described below. Apparently, the figures that are described below are merely a part of the embodiments of the present disclosure, and a person skilled in the art can obtain other figures according to these figures without paying creative work.
FIG. 1 illustrates a schematic structural diagram of a solar cell sheet according to an embodiment of the present disclosure;
FIG. 2 illustrates a schematic diagram of connection of solar cell slices according to an embodiment of the present disclosure;
FIG. 3 illustrates a schematic structural diagram of a solar cell slice according to an embodiment of the present disclosure;
FIG. 4 illustrates a schematic structural diagram of another solar cell slice according to an embodiment of the present disclosure; and
FIG. 5 illustrates a cross-sectional schematic diagram of a solar cell sheet according to an embodiment of the present disclosure.

### DETAILED DESCRIPTION

The technical solutions according to the embodiments of the present disclosure will be clearly and completely described below with reference to the drawings according to the embodiments of the present disclosure. Apparently, the described embodiments are merely a part of the embodiments of the present disclosure, rather than all of the embodiments. All of the other embodiments that a person skilled in the art obtains on the basis of the embodiments of the present disclosure without paying creative work fall within the protection scope of the present disclosure.

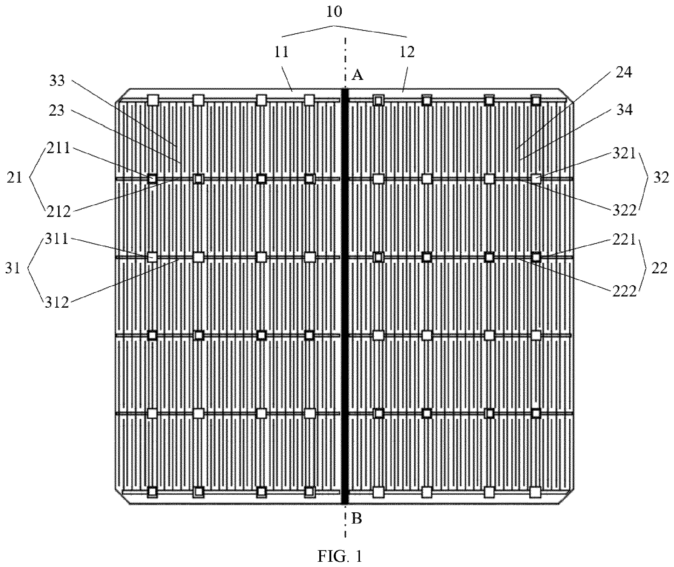

Referring to FIG. 1, FIG. 1 illustrates a schematic structural diagram of a solar cell sheet according to an embodiment of the present disclosure. The solar cell sheet may include: a semiconductor substrate 10, and a positive electrode and a negative electrode that are arranged on a shadow surface of the semiconductor substrate 10.

Among them, the semiconductor substrate 10 may include a first substrate portion 11 and a second substrate portion 12 that are symmetrically arranged along a central line AB of the semiconductor substrate 10. Correspondingly, the positive electrode may include a first positive electrode portion 21 arranged in the first substrate portion 11 and a second positive electrode portion 22 arranged in the second substrate portion 12; the negative electrode may include a first negative electrode portion 31 arranged in the first substrate portion 11 and a second negative electrode portion 32 arranged in the second substrate portion 12.

Specifically, the first positive electrode portion 21 and the first negative electrode portion 31 are arranged in parallel in the first substrate portion 11 of the solar cell sheet, the first positive electrode portion 21 and the first negative electrode portion 31 extend along a direction intersecting with the central line AB. Furthermore, the first positive electrode portion 21 and the first negative electrode portion 31 may be perpendicular to the central line AB. The second positive electrode portion 22 and the second negative electrode portion 32 are arranged in parallel in the second substrate portion 12 of the solar cell sheet, the second positive electrode portion 22 and the second negative electrode portion 32 extend along the direction intersecting with the central line AB. Furthermore, the second positive electrode portion 22 and the second negative electrode portion 32 may be perpendicular to the central line AB. At this point, in the first substrate portion 11 and the second substrate portion 12, an extension direction of the first positive electrode portion 21 located in the first substrate portion 11 and an extension direction of the second negative electrode portion 32 located in the second substrate portion 12 coincide, which can be connected to both ends of the conductive wire, respectively; and an extension direction of the first negative electrode portion 31 located in the first substrate portion 11 and an extension direction of the second positive electrode portion 22 located in the second substrate portion 12 coincide, which can be connected to both ends of another conductive wire, respectively.

In the embodiment of the present disclosure, the above solar cell sheet may be cut along the central line AB to obtain two cell slices.

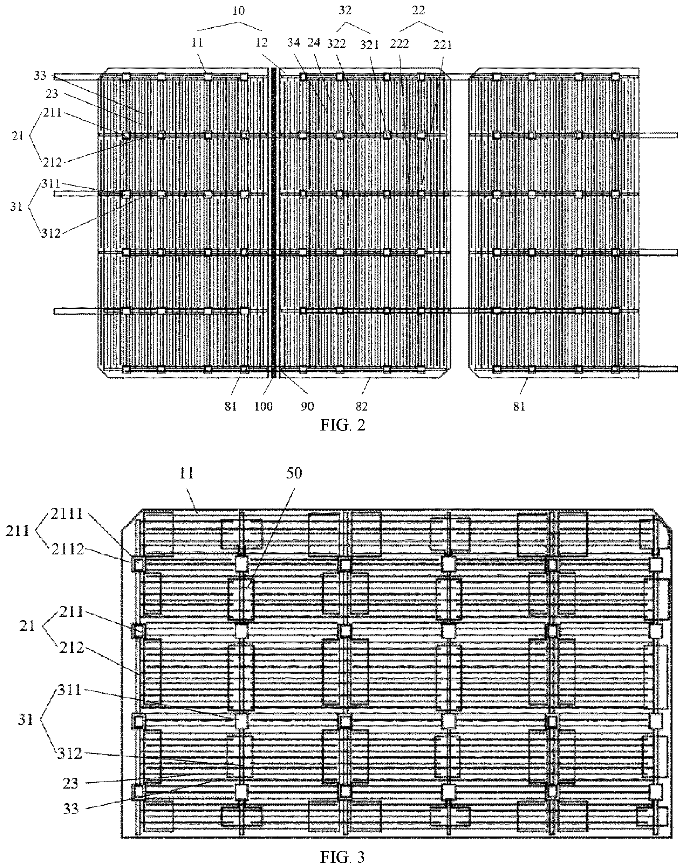

Referring to FIG. 2, FIG. 2 illustrates a schematic diagram of connection of solar cell slices according to an embodiment of the present disclosure, the solar cell sheet is cut by laser non-destructive cutting along the central line AB to obtain two cell slices: a first slice 81 and a second slice 82; and the first slice 81 and the second slice 82 obtained by cutting respectively correspond to the first substrate portion 11 and the second substrate portion 12, the extension direction of the first positive electrode portion 21 in the first substrate portion 11 and the extension direction of the second negative electrode portion 32 in the second substrate portion 12 coincide, and the extension direction of the first negative electrode portion 31 in the first substrate portion 11 and the extension direction of the second positive electrode portion 22 in the second substrate portion 12 coincide.

Therefore, after cutting, there is no need to rotate one of the cell slices 180 degrees and align them. Instead, after cutting the solar cell sheet, the positions of the two cell slices do not need to be changed, that is, there is no need to rotate one of the slices and align them, a conductive wire (welding strip) 90 can be directly arranged between the two cell slices, and one end of the conductive wire 90 is connected to the first positive electrode portion 21 in the first slice 81, the other end of the conductive wire 90 is connected to the second negative electrode portion 32 in the second slice 82, thereby conducting the two cell slices.

Correspondingly, the second slice 82 can also be connected to another first slice 81 obtained by cutting another solar cell sheet through the conductive wire 90. Specifically, one end of the conductive wire 90 is connected to the second positive electrode portion 22 in the second slice 82, and the other end of the conductive wire 90 is connected to the first negative electrode portion 31 in another first slice 81, thereby conducting the two cell slices. Subsequently, a plurality of solar cell slices are connected and assembled to obtain a photovoltaic assembly.

In addition, when the solar cell sheet is a rectangular structure with four chamfers, if the solar cell sheet is cut to obtain two cell slices, each cell slice has two chamfers, and one of the cell slices is rotated 180 degrees to assemble into the photovoltaic assembly, the two chamfers in each cell slice of the photovoltaic assembly are located in the same position and arranged towards the same direction, making the appearance of the photovoltaic assembly not aesthetically pleasing. Referring to FIG. 2, in the embodiment of the present disclosure, the overall appearance of the first slice 81 and the second slice 82 connected by the conductive wire 90 is basically consistent with the appearance of the solar cell sheet before cutting, with all four chamfers located at the four top corners of the solar cell sheet, thus having a better visual effect.

To sum up, in the embodiment of the present disclosure, the solar cell sheet includes: the semiconductor substrate, and the positive electrode and the negative electrode that are arranged on a shadow surface of the semiconductor substrate; the semiconductor substrate includes a first substrate portion and a second substrate portion that are symmetrically arranged along a central line of the semiconductor substrate; the positive electrode includes a first positive electrode portion arranged in the first substrate portion and a second positive electrode portion arranged in the second substrate portion, the negative electrode includes a first negative electrode portion arranged in the first substrate portion and a second negative electrode portion arranged in the second substrate portion; the first positive electrode portion and the first negative electrode portion are arranged in parallel in the first substrate portion, the second positive electrode portion and the second negative electrode portion are arranged in parallel in the second substrate portion; and in the first substrate portion and the second substrate portion, an extension direction of the first positive electrode portion and an extension direction of the second negative electrode portion coincide, and an extension direction of the first negative electrode portion and an extension direction of the second positive electrode portion coincide. In the present disclosure, two slices can be obtained by cutting the solar cell sheet along the central line, since in the first substrate portion and the second substrate portion corresponding to the two slices respectively, the extension directions of the first positive electrode portion and the second negative electrode portion coincide the first positive electrode portion and the second negative electrode portion can be connected to both ends of the conductive wire respectively. Since the extension directions of the first negative electrode portion and the second positive electrode portion coincide, the first negative electrode portion and the second positive electrode portion can be connected to both ends of another conductive wire. The two slices can be directly connected in series through the conductive wires after cutting, without the need to rotate one of them or align them, thus simplifying the process operation steps and improving the production efficiency and yield of the photovoltaic assembly.

Optionally, referring to FIG. 1, in the first substrate portion 11, the first positive electrode portion 21 may include a plurality of first positive-electrode connection points 211 for connecting to a conductive wire, and first positive-electrode connection grid lines 212 connecting adjacent first positive-electrode connection points 211; the first negative electrode portion 31 may include a plurality of first negative-electrode connection points 311 for connecting to the conductive wire, and first negative-electrode connection grid lines 312 connecting adjacent first negative-electrode connection points 311.

Correspondingly, in the second substrate portion 12, the second positive electrode portion 22 may include a plurality of second positive-electrode connection points 221 for connecting to the conductive wire, and second positive-electrode connection grid lines 222 connecting adjacent second positive-electrode connection points 221; the second negative electrode portion 32 may include a plurality of second negative-electrode connection points 321 for connecting to the conductive wire, and second negative-electrode connection grid lines 322 connecting adjacent second negative-electrode connection points 321.

Specifically, when using a conductive wire (welding strip) to connect the solar cell slices obtained by cutting the solar cell sheet, the first positive-electrode connection points 211, the first negative-electrode connection points 311, the second positive-electrode connection points 221, and the second negative-electrode connection points 321 can be used as solder pads to be welded with the welding strips, so that the welding strips extend along the first positive electrode portion 21 and the second negative electrode portion 32, or along the first negative electrode portion 31 and the second positive electrode portion 22.

Optionally, referring to FIG. 1, in the solar cell sheet, the positive electrode further includes a first positive-electrode fine grid portion 23 arranged in the first substrate portion 11 and a second positive-electrode fine grid portion 24 arranged in the second substrate portion 12; the negative electrode further includes a first negative-electrode fine grid portion 33 arranged in the first substrate portion 11 and a second negative-electrode fine grid portion 34 arranged in the second substrate portion 12.

Among them, the first positive-electrode fine grid portion 23 and the first negative-electrode fine grid portion 33 are parallel and spaced apart from each other, that is, the first positive-electrode fine grid portion 23 and the first negative-electrode fine grid portion 33 are arranged in a finger shaped intersection. One end of the first positive-electrode fine grid portion 23 is connected to the first positive electrode portion 21, the other end of the first positive-electrode fine grid portion 23 is separated by a first preset distance from the first negative electrode portion 31; one end of the first negative-electrode fine grid portion 33 is connected to the first negative electrode portion 31, and the other end of the first negative-electrode fine grid portion 33 is separated by a second preset distance from the first positive electrode portion 21. Correspondingly, the second positive-electrode fine grid portion 24 and the second negative-electrode fine grid portion 34 are parallel and spaced apart from each other, that is, the second positive-electrode fine grid portion 24 and the second negative-electrode fine grid portion 34 are arranged in the finger shaped intersection. One end of the second positive-electrode fine grid portion 24 is connected to the second positive electrode portion 22, the other end of the second positive-electrode fine grid portion 24 is separated by a third preset distance from the second negative electrode portion 32, one end of the second negative-electrode fine grid portion 34 is connected to the second negative electrode portion 32, and the other end of the second negative-electrode fine grid portion 34 is separated by a fourth preset distance from the second positive electrode portion 22.

In the embodiment of the present disclosure, in the first substrate portion 11, since the first positive-electrode fine grid portion 23 is distributed on the surface of the first substrate portion 11, for collecting positively charged carriers generated on the surface of the first substrate portion 11, and transfer and converge the collected positively charged carriers to the first positive electrode portion 21, that is, to form current and converge in the first positive-electrode fine grid portion 23 and the first positive electrode portion 21. The first negative-electrode fine grid portion 33 is also distributed on the surface of the first substrate portion 11, for collecting negatively charged carriers generated on the surface of the first substrate portion 11, and transfer and converge the collected negatively charged carriers to the first negative electrode portion 31, that is, to form current and converge in the first negative-electrode fine grid portion 33 and the first negative electrode portion 31. Therefore, the first positive-electrode fine grid portion 23 is connected to the first positive electrode portion 21, and is separated from the first negative electrode portion 31 by the first preset distance, that is, one end of the first positive-electrode fine grid portion 23 is connected to the first positive electrode portion 21, and the other end of the first positive-electrode fine grid portion 23 is separated from the first negative electrode portion 31 by the first preset distance, achieving disconnection from the first negative electrode portion 31 and avoiding short circuits. The first negative-electrode fine grid portion 33 is connected to the first negative electrode portion 31, and is separated from the first positive electrode portion 21 by the second preset distance, that is, one end of the first negative-electrode fine grid portion 33 is connected to the first negative electrode portion 31, and the other end of the first negative-electrode fine grid portion 33 is separated from the first positive electrode portion 21 by the second preset distance, achieving disconnection from the first positive electrode portion 21 and avoiding short circuits.

Correspondingly, in the second substrate portion 12, since the second positive-electrode fine grid portion 24 is distributed on the surface of the second substrate portion 12, for collecting positively charged carriers generated on the surface of the second substrate portion 12, and transfer and converge the collected positively charged carriers to the second positive electrode portion 22, that is, to form current and converge in the second positive-electrode fine grid portion 24 and the second positive electrode portion 22. The second negative-electrode fine grid portion 34 is also distributed on the surface of the second substrate portion 12, for collecting negatively charged carriers generated on the surface of the second substrate portion 12, and transfer and converge the collected negatively charged carriers to the second negative electrode portion 32, that is, to form current and converge in the second negative-electrode fine grid portion 34 and the second negative electrode portion 32. Therefore, the second positive-electrode fine grid portion 24 is connected to the second positive electrode portion 22, and is separated from the second negative electrode portion 32 by the third preset distance, that is, one end of the second positive-electrode fine grid portion 24 is connected to the second positive electrode portion 22, and the other end of the second positive-electrode fine grid portion 24 is separated from the second negative electrode portion 32 by the third preset distance, achieving disconnection from the second negative electrode portion 32 and avoiding short circuits. The second negative-electrode fine grid portion 34 is connected to the second negative electrode portion 32, and is separated from the second positive electrode portion 22 by the fourth preset distance, that is, one end of the second negative-electrode fine grid portion 34 is connected to the second negative electrode portion 32, and the other end of the second negative-electrode fine grid portion 34 is separated from the second positive electrode portion 22 by the fourth preset distance, achieving disconnection from the second positive electrode portion 22 and avoiding short circuits.

Among them, the first preset distance, the second preset distance, the third preset distance, and the fourth preset distance may be equal or not equal. The first preset distance, the second preset distance, the third preset distance, and the fourth preset distance may be the distance between the positive electrode portion and the fine grid portion with opposite polarity when there is no short circuit.

Specifically, when using a welding strip to connect the first positive electrode portion 21 and the second negative electrode portion 32, or the first negative electrode portion 31 and the second positive electrode portion 22, a slight deviation of the welding strip can cause the welding strip to come into contact with the fine grid portion has the opposite polarity, resulting in a short circuit. For example, when using the welding strip to connect the first positive electrode portion 21, if the position of the welding strip is offset, it can cause the welding strip to come into contact with the first negative-electrode fine grid portion 33. Furthermore, the first positive electrode portion 21 and the first negative-electrode fine gate portion 33 are connected, causing a short circuit due to the presence of carriers with opposite polarities in the first positive electrode portion 21 and the first negative-electrode fine gate portion 33. From this, it can be seen that when using the welding strips to interconnect the solar cell slices to form the photovoltaic assembly, the positioning accuracy and operational requirements for welding the welding strips are high, resulting in a low yield rate of the prepared photovoltaic assembly.

Optionally, the solar cell sheet may further include an insulation layer 50. Referring to FIG. 3, FIG. 3 illustrates a schematic structural diagram of a solar cell slice according to an embodiment of the present disclosure. In the cell slice, the insulation layer 50 may be arranged between adjacent first positive-electrode connection points 211, and cover a part of the first negative-electrode fine grid portion 33 close to the first positive-electrode connection grid line 212 and between adjacent first positive-electrode connection points 211, that is, the insulation layer 50 covers a part of the first negative-electrode fine grid portion 33 that is closest to the first positive-electrode connection grid line 212. Therefore, the insulation layer 50 can serve to isolate the first negative-electrode fine grid portion 33 and the first positive-electrode connection grid line 212. Therefore, when using the welding strips to interconnect the solar cell slices to form the photovoltaic assembly, even if the welding strip arranged at the position corresponding to the first positive electrode portion 21 and connected to the first positive-electrode connection points 211 is offset to a certain extent, it will not cause the welding strip to come into contact with the first negative-electrode fine grid portion 33, thereby avoiding conduction between the first positive electrode portion 21 and the first negative-electrode fine grid portion 33. Alternatively, the insulation layer 50 may be arranged between adjacent first negative-electrode connection points 311, and cover a part of the first positive-electrode fine grid portion 23 close to the first negative-electrode connection grid line 312 and between adjacent first negative-electrode connection points 311, that is, the insulation layer 50 covers a part of the first positive-electrode fine grid portion 23 that is closest to the first negative-electrode connection grid line 312. Therefore, the insulation layer 50 can serve to isolate the first positive-electrode fine grid portion 23 and the first negative-electrode connection grid line 312. Therefore, when using the welding strips to interconnect the solar cell slices to form the photovoltaic assembly, even if the welding strip arranged at the position corresponding to the first negative electrode portion 31 and connected to the first negative-electrode connection points 311 is offset to a certain extent, it will not cause the welding strip to come into contact with the first positive-electrode fine grid portion 23, thereby avoiding conduction between the first negative electrode portion 31 and the first positive-electrode fine grid portion 23. That is, the insulation layer 50 can avoid short circuit between the first positive electrode portion 21 and the first negative-electrode fine grid portion 33, and between the first negative electrode portion 31 and the first positive-electrode fine grid portion 23. Which can reduce the positioning accuracy and operational requirements during welding the welding strip, and improve the yield rate of the final prepared photovoltaic assembly.

In another cell slice corresponding to FIG. 3, the insulation layer 50 may be arranged between adjacent second positive-electrode connection points 221, and covers a part of the second negative-electrode fine grid portion 34 close to the second positive-electrode connection grid line 222 and between adjacent second positive-electrode connection points 221, that is, the insulation layer 50 covers a part of the second negative-electrode fine grid portion 34 that is closest to the second positive-electrode connection grid line 222. Therefore, the insulation layer 50 can serve to isolate the second negative-electrode fine grid portion 34 and the second positive-electrode connection grid line 222. Therefore, when using the welding strips to interconnect the solar cell slices to form the photovoltaic assembly, even if the welding strip arranged at the position corresponding to the second positive electrode portion 22 and connected to the second positive-electrode connection points 221 is offset to a certain extent, it will not cause the welding strip to come into contact with the second negative-electrode fine grid portion 34, thereby avoiding conduction between the second positive electrode portion 22 and the second negative-electrode fine grid portion 34. Alternatively, the insulation layer 50 may be arranged between adjacent second negative-electrode connection points 321, and covers a part of the second positive-electrode fine grid portion 24 close to the second negative-electrode connection grid line 322 and between adjacent second negative-electrode connection points 321, that is, the insulation layer 50 covers a part of the second positive-electrode fine grid portion 24 that is closest to the second negative-electrode connection grid line 322. Therefore, the insulation layer 50 can serve to isolate the second positive-electrode fine grid portion 24 and the second negative-electrode connection grid line 322. Therefore, when using the welding strips to interconnect the solar cell slices to form the photovoltaic assembly, even if the welding strip arranged at the position corresponding to the second negative electrode portion 32 and connected to the second negative-electrode connection points 321 is offset to a certain extent, it will not cause the welding strip to come into contact with the second positive-electrode fine grid portion 24, thereby avoiding conduction between the second negative electrode portion 32 and the second positive-electrode fine grid portion 24. That is, the insulation layer 50 can avoid short circuit between the second positive electrode portion 22 and the second negative-electrode fine grid portion 34, and between the second negative electrode portion 32 and the second positive-electrode fine grid portion 24. Which can reduce the positioning accuracy and operational requirements during welding the welding strip, and improve the yield rate of the final prepared photovoltaic assembly.

In an embodiment of the present disclosure, referring to FIG. 3, in the cell slice, the insulation layers 50 may also be arranged between the first positive-electrode connection point 211 at a boundary of a solar cell slice and the boundary of the solar cell slice, and between the first negative-electrode connection point 311 at the boundary of the solar cell slice and the boundary of the solar cell slice, since the offset of the conductive wire in the boundary area of the solar cell slice is generally larger, sizes (widths) of the insulation layers 50, arranged between the first positive-electrode connection point 211 and the boundary of the solar cell slice and between the first negative-electrode connection point 311 and the boundary of the solar cell slice along a direction parallel to the central line AB of the semiconductor substrate 10, are greater than sizes (widths) of the insulation layers 50 arranged between two adjacent first positive-electrode connection points 211 and between two adjacent first negative-electrode connection points 311 along the direction parallel to the central line AB of the semiconductor substrate 10, which can improve the reliability of the connection of the conductive wire.

In addition, the insulation layers 50, located between two adjacent first positive-electrode connection points 211 and between the first positive-electrode connection point 211 and the boundary of the solar cell slice, may cover the first positive-electrode connection grid line 212 and the part of the first positive-electrode fine grid portion 23 close to the first positive-electrode connection grid line 212 at the same time, which makes the insulation layer 50 between the two adjacent first positive-electrode connection points 211 form an integral structure. The insulation layers 50, located between two adjacent first negative-electrode connection points 311 and between the first negative-electrode connection point 311 and the boundary of the solar cell slice, may cover the first negative-electrode connection grid line 312 and the part of the first negative-electrode fine grid portion 24 close to the first negative-electrode connection grid line 312 at the same time, which makes the insulation layer 50 between the two adjacent first negative-electrode connection points 311 form the integral structure.

In an embodiment of the present disclosure, the size (width) of the insulation layer 50 along the direction parallel to the central line AB of the semiconductor substrate 10 is greater than sizes (width) of the first positive-electrode connection points 211 and the first negative-electrode connection point 311 along the direction parallel to the central line AB of the semiconductor substrate 10, and is also greater than a size (width) of the conductive wire along the direction parallel to the central line AB of the semiconductor substrate 10.

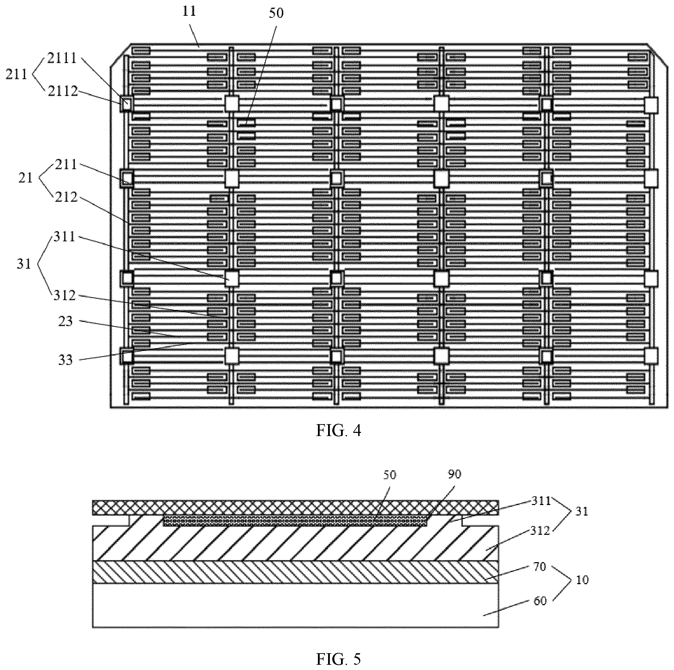

Referring to FIG. 4, FIG. 4 illustrates a schematic structural diagram of another solar cell slice according to an embodiment of the present disclosure. In the solar cell slice, the insulation layers 50, located between two adjacent first positive-electrode connection points 211 and between the first positive-electrode connection point 211 and the boundary of the solar cell slice, merely cover the part of the first negative-electrode fine grid portion 33 close to the first positive-electrode connection grid line 212, but do not cover the part of the first positive-electrode fine grid portion 23 close to the first positive-electrode connection grid line 212 and the first positive-electrode connection grid line 212, which makes the insulation layers 50 form a dispersed structure. The insulation layers 50, located between two adjacent first negative-electrode connection points 311 and between the first negative-electrode connection point 311 and the boundary of the solar cell slice, merely cover the part of the first positive-electrode fine grid portion 23 close to the first negative-electrode connection grid line 312, but do not cover the part of the first negative-electrode fine grid portion 33 close to the first negative-electrode connection grid line 312 and the first negative-electrode connection grid line 312, which makes the insulation layers 50 form the dispersed structure. Thus, saving the amount of insulation material used to prepare the insulation layer 50, reducing costs, and arranging a plurality of dispersed insulation layers 50 in a direction perpendicular to the central line of the semiconductor substrate 10.

Optionally, referring to FIG. 1, structures of the first positive-electrode connection points 211, the first negative-electrode connection points 311, the second positive-electrode connection points 221 and the second negative-electrode connection points 321 of the solar cell sheet may be square structures, side lengths of the square structures are 600-1500 millimeters.

Widths of the first positive-electrode connection grid lines 212, the first negative-electrode connection grid lines 312, the second positive-electrode connection grid lines 222 and the second negative-electrode connection grid lines 322 of the solar cell sheet may be 150-400 millimeters.

In the solar cell sheet, widths of the first positive-electrode fine grid portion 23 and the second positive-electrode fine grid portion 24 may be 60-200 millimeters; and widths of the first negative-electrode fine grid portion 33 and the second negative-electrode fine grid portion 34 may be 20-60 millimeters.

Optionally, referring to FIG. 3, each of the first positive-electrode connection points 211 may include a central portion 2111 and an outer edge portion 2112 arranged at an outer side of the central portion 2111. Among them, a structure of the central portion 2111 is the square structure, side lengths of the central portion 2111 may be 600-1200 millimeters; an inner contour of the outer edge portion 2112 and an outer contour of the central portion 2111 overlap with each other, an outer contour of the outer edge portion 2112 and the inner contour are parallel to each other, and side lengths of the outer contour of the outer edge portion 2112 may be 800-1600 millimeters.

Correspondingly, the second positive-electrode connection points 221 may have the same structure as the first positive-electrode connection points 211.

Optionally, the central portion 2111 may be a silver electrode prepared using silver paste, and the outer edge portion 2112 may be an aluminum electrode prepared using aluminum paste, thereby reducing the amount of silver used and saving costs.

Optionally, FIG. 5 illustrates a cross-sectional schematic diagram of a solar cell sheet according to an embodiment of the present disclosure. Referring to FIG. 5, the semiconductor substrate 10 of the solar cell sheet may include a silicon substrate 60, and a semiconductor region 70 arranged at a shadow surface of the silicon substrate 60 and including a first semiconductor region and a second semiconductor region.

Specifically, the positive electrode in the solar cell sheet is arranged on a side of the first semiconductor region away from the silicon substrate 60, and the negative electrode is arranged on a side of the second semiconductor region away from the silicon substrate 60.

Among them, the first semiconductor region can be a P-type semiconductor region composed of a P-type diffusion region formed at the shadow surface of the silicon substrate 60, and the second semiconductor region can be an N-type semiconductor region composed of an N-type diffusion region formed at the shadow surface of the silicon substrate 60. That is, the positive electrode in the solar cell sheet is arranged on the P-type semiconductor region on the shadow surface of the semiconductor substrate 10, and the negative electrode is arranged on the N-type semiconductor region on the shadow surface of the semiconductor substrate 10.

In an embodiment of the present disclosure, the first semiconductor region may be continuously arranged on the silicon substrate 60 in the region corresponding to the first positive-electrode connection points 211 and the second positive-electrode connection points 221, for adjacent first positive-electrode connection points 211 to be connected through the first positive-electrode connection grid line 212, and for adjacent second positive-electrode connection points 221 to be connected through the second positive-electrode connection grid line 222. The second semiconductor region may be continuously arranged on the silicon substrate 60 in the region corresponding to the first negative-electrode connection points 311 and the second negative-electrode connection points 321, for adjacent first negative-electrode connection points 311 to be connected through the first negative-electrode connection grid line 312, and for adjacent second negative-electrode connection points 321 to be connected through the second negative-electrode connection grid line 322. Since the positive-electrode connection points located at the boundary of the silicon substrate 60 can be connected without the need for a positive-electrode connection gate line, and the negative-electrode connection points can be connected without the need for a negative-electrode connection gate line, the first semiconductor region and the second semiconductor region located at the boundary of the silicon substrate 60 can be discontinuous.

In addition, referring to FIG. 3 and FIG. 4, the insulation layer 50 arranged between adjacent first negative-electrode connection points 311 can be spaced at a certain distance from the first negative-electrode connection points 311. Referring to FIG. 5, the insulation layer 50 arranged between adjacent first-negative electrode connection points 311 can also be connected to the first negative-electrode connection point 311, that is, the insulation layer 50 completely fills the region between the first negative-electrode connection point 311, thus completely avoiding contact between the conductive wire 90 located above the insulation layer 50 and the fine grid electrode with opposite polarity.

To sum up, in the embodiments of the present disclosure, the solar cell sheet includes: a semiconductor substrate, and a positive electrode and a negative electrode that are arranged on a shadow surface of the semiconductor substrate; the semiconductor substrate includes a first substrate portion and a second substrate portion that are symmetrically arranged along a central line of the semiconductor substrate; the positive electrode includes a first positive electrode portion arranged in the first substrate portion and a second positive electrode portion arranged in the second substrate portion, the negative electrode includes a first negative electrode portion arranged in the first substrate portion and a second negative electrode portion arranged in the second substrate portion; the first positive electrode portion and the first negative electrode portion are arranged in parallel in the first substrate portion, the second positive electrode portion and the second negative electrode portion are arranged in parallel in the second substrate portion; and in the first substrate portion and the second substrate portion, an extension direction of the first positive electrode portion and an extension direction of the second negative electrode portion coincide, and an extension direction of the first negative electrode portion and an extension direction of the second positive electrode portion coincide. In the present disclosure, two slices can be obtained by cutting the solar cell sheet along the central line, since in the first substrate portion and the second substrate portion corresponding to the two slices respectively, the extension directions of the first positive electrode portion and the second negative electrode portion coincide, the first positive electrode portion and the second negative electrode portion can be connected to both ends of the conductive wire respectively. Since the extension directions of the first negative electrode portion and the second positive electrode portion coincide, the first negative electrode portion and the second positive electrode portion can be connected to both ends of another conductive wire. The two slices can be directly connected in series through the conductive wires after cutting, without the need to rotate one of them or align them, thus simplifying the process operation steps and improving the production efficiency and yield of the photovoltaic assembly.

The embodiment of the present disclosure also provides a solar cell slice, and the solar cell slice includes: a first slice and a second slice that are obtained by cutting the above solar cell sheet along the central line of the semiconductor substrate.

Among them, referring to FIG. 1, the semiconductor substrate 10 includes the first substrate portion 11 and the second substrate portion 12 that are symmetrically arranged along the central line AB of the semiconductor substrate10.

Referring to FIG. 2, the above solar cell sheet is cut by laser non-destructive cutting along the central line AB to obtain two cell slices: a first slice 81 and a second slice 82; and the first slice 81 and the second slice 82 obtained by cutting correspond to the first substrate portion 11 and the second substrate portion 12, respectively.

The first slice 81 includes the first substrate portion 11, and the first positive electrode portion 21 and the first negative electrode portion 31 that are arranged in the first substrate portion 11, the first positive electrode portion 21 and the first negative electrode portion 31 are arranged in parallel. The second slice 82 includes the second substrate portion 12, and the second positive electrode portion 22 and the second negative electrode portion 32 that are arranged in the second substrate portion 12, the second positive electrode portion 22 and the second negative electrode portion 32 are arranged in parallel.

Meanwhile, the extension direction of the first positive electrode portion 21 in the first slice 81 and the extension direction of the second negative electrode portion 32 in the second slice 82 coincide, which can be connected to both ends of one conductive wire 90. The extension direction of the first negative electrode portion 31 in the first slice 81 and the extension direction of the second positive electrode portion 22 in the second slice 82 coincide, which can be connected to both ends of another conductive wire 90. Therefore, after cutting the solar cell sheet to obtain the first slice 81 and the second slice 82, there is no need to rotate one of the cell slice 180 degrees or align them. Instead, the position of the two cell slices can be unchanged, that is, one of the cell slices does not need to be rotated or aligned. A conductive wire (welding strip) 90 can be directly arranged between the two cell slices, one end of the conductive wire 90 is connected to the first positive electrode portion 21 in the first slice 81, and the other end of the conductive wire 90 is connected to the second negative electrode portion 32 in the second slice 82, thereby conducting the two cell slices.

Correspondingly, the second slice 82 can also be connected to another first slice 81 obtained by cutting another solar cell sheet through the conductive wire 90. Specifically, one end of the conductive wire 90 is connected to the second positive electrode portion 22 in the second slice 82, and the other end of the conductive wire 90 is connected to the first negative electrode sub section 31 in another first slice 81, thereby conducting the two cell slices. Subsequently, the plurality of solar cell slices are connected and assembled into the photovoltaic assembly.

In the embodiment of the present disclosure, the cut solar cell slices are significantly smaller in size compared to the solar cell sheet, so the current generated by each solar cell slice is smaller than that of the entire solar cell sheet. It is preferred that the cut solar cell slices be half the size of the undivided solar cell sheet, so that the power loss caused by the series resistance connected by the conductive wire can be reduced to one fourth of the original.

The embodiment of the present disclosure further provides a photovoltaic assembly, and the photovoltaic assembly includes a plurality of solar cell slices described above and a plurality of conductive wires.

Referring to FIG. 2, the first slice 81 and the second slice 82 of the plurality of solar cell slices are separated, one end of one conductive wire 90 is connected to the first positive electrode portion 21 of the first slice 81, the other end of the conductive wire 90 is connected to the second negative electrode portion 32 of adjacent second slice 82; one end of another conductive wire 90 is connected to the first negative electrode portion 31 of the first slice 81, and the other end of the another conductive wire 90 is connected to the second positive electrode portion 22 of adjacent second slice 82. So as to conduct the two solar cell slices and further collect the current generated and converged in the solar cell slices.

Optionally, the photovoltaic assembly further includes a connecting part 100, the connecting part 100 is arranged between the first slice 81 and the second slice 82 that are adjacent, the connecting part 100 extends along the central line of the semiconductor substrate, and is electrically connected to the conductive wire 90 connecting the first slice 81 and the second slice 82 that are adjacent.

In the embodiment of the present disclosure, the connecting material 100 can have the same material as the conductive wire 90, for example, using metal materials mainly containing copper, such as tin plated copper welding strips. The connecting material 100 electrically connects the plurality of conductive wires 90 connecting the first slice 81 and the second slice 82, which provides additional current channels. When there is virtual soldering or obstruction in some regions of the conductive wires 90, current can flow through these nearby channels to adjacent cell slices, thus reducing current mismatch and improving the output of the components.

It should be noted that in the specification, the terms "including", "comprising", or any other variation thereof are intended to encompass non-exclusive inclusion, such that a process, method, item, or device that includes a series of elements not only includes those elements, but also includes other elements that are not explicitly listed, or also includes elements inherent to such a process, method, item, or device. Without further limitations, the element limited by the statement "including a..." does not exclude the existence of another identical element in the process, method, item, or device that includes that element.

Through the description of the above implementations, persons skilled in the art can clearly understand that the above implementations can be achieved through software and necessary general hardware platforms, and certainly, hardware can also be used. However, in many cases, the former is the better implementation. Based on this understanding, the technical solution disclosed herein can essentially or in other words, contribute to the prior art in the form of a software product, which is stored in a storage medium (such as ROM/RAM, disk, optical disc), including several instructions to enable a terminal (which can be a mobile phone, computer, server, air conditioner, or network device, etc.) to execute the methods described in various embodiments of the present disclosure.

The embodiments of the present disclosure are described above in conjunction with the accompanying drawings, but the present disclosure is not limited to the specific embodiments mentioned above. The specific embodiments mentioned above are only illustrative and not restrictive. With the inspiration of the present disclosure, persons skilled in the art can also make many forms without departing from the scope protected by the purpose and claims of the present disclosure, all of which fall within the scope of protection of the present disclosure.

## Claims

1. A solar cell sheet, **characterized in that** the solar cell sheet comprises:
a semiconductor substrate, and a positive electrode and a negative electrode that are arranged on a shadow surface of the semiconductor substrate;
the semiconductor substrate comprises a first substrate portion and a second substrate portion that are symmetrically arranged along a central line of the semiconductor substrate;
the positive electrode comprises a first positive electrode portion arranged in the first substrate portion and a second positive electrode portion arranged in the second substrate portion, the negative electrode comprises a first negative electrode portion arranged in the first substrate portion and a second negative electrode portion arranged in the second substrate portion;
the first positive electrode portion and the first negative electrode portion are arranged in parallel in the first substrate portion, the second positive electrode portion and the second negative electrode portion are arranged in parallel in the second substrate portion; and
in the first substrate portion and the second substrate portion, an extension direction of the first positive electrode portion and an extension direction of the second negative electrode portion coincide, and an extension direction of the first negative electrode portion and an extension direction of the second positive electrode portion coincide.

2. The solar cell sheet according to claim 1, **characterized in that**
the solar cell sheet is cut by laser non-destructive cutting along the central line to obtain two cell slices: a first slice and a second slice; and
the first slice and the second slice obtained by cutting respectively correspond to the first substrate portion and the second substrate portion, the extension direction of the first positive electrode portion in the first substrate portion and the extension direction of the second negative electrode portion in the second substrate portion coincide, and the extension direction of the first negative electrode portion in the first substrate portion and the extension direction of the second positive electrode portion in the second substrate portion coincide.

3. The solar cell sheet according to claim 1, **characterized in that**
the first positive electrode portion comprises a plurality of first positive-electrode connection points for connecting to a conductive wire, and first positive-electrode connection grid lines connecting adjacent first positive-electrode connection points; the first negative electrode portion comprises a plurality of first negative-electrode connection points for connecting to the conductive wire, and first negative-electrode connection grid lines connecting adjacent first negative-electrode connection points; and
the second positive electrode portion comprises a plurality of second positive-electrode connection points for connecting to the conductive wire, and second positive-electrode connection grid lines connecting adjacent second positive-electrode connection points; the second negative electrode portion comprises a plurality of second negative-electrode connection points for connecting to the conductive wire, and second negative-electrode connection grid lines connecting adjacent second negative-electrode connection points.

4. The solar cell sheet according to claim 3, **characterized in that** the positive electrode further comprises a first positive-electrode fine grid portion arranged in the first substrate portion and a second positive-electrode fine grid portion arranged in the second substrate portion; the negative electrode further comprises a first negative-electrode fine grid portion arranged in the first substrate portion and a second negative-electrode fine grid portion arranged in the second substrate portion;
the first positive-electrode fine grid portion and the first negative-electrode fine grid portion are parallel and spaced apart from each other, one end of the first positive-electrode fine grid portion is connected to the first positive electrode portion, the other end of the first positive-electrode fine grid portion is separated by a first preset distance from the first negative electrode portion; one end of the first negative-electrode fine grid portion is connected to the first negative electrode portion, and the other end of the first negative-electrode fine grid portion is separated by a second preset distance from the first positive electrode portion; and
the second positive-electrode fine grid portion and the second negative-electrode fine grid portion are parallel and spaced apart from each other, one end of the second positive-electrode fine grid portion is connected to the second positive electrode portion, the other end of the second positive-electrode fine grid portion is separated by a third preset distance from the second negative electrode portion, one end of the second negative-electrode fine grid portion is connected to the second negative electrode portion, and the other end of the second negative-electrode fine grid portion is separated by a fourth preset distance from the second positive electrode portion.

5. The solar cell sheet according to claim 4, **characterized in that** the solar cell sheet further comprises: an insulation layer;
the insulation layer is arranged between adjacent first positive-electrode connection points, and covers a part of the first negative-electrode fine grid portion close to the first positive-electrode connection grid line and between adjacent first positive-electrode connection points; or
the insulation layer is arranged between adjacent second positive-electrode connection points, and covers a part of the second negative-electrode fine grid portion close to the second positive-electrode connection grid line and between adjacent second positive-electrode connection points; or
the insulation layer is arranged between adjacent first negative-electrode connection points, and covers a part of the first positive-electrode fine grid portion close to the first negative-electrode connection grid line and between adjacent first negative-electrode connection points; or
the insulation layer is arranged between adjacent second negative-electrode connection points, and covers a part of the second positive-electrode fine grid portion close to the second negative-electrode connection grid line and between adjacent second negative-electrode connection points.

6. The solar cell sheet according to claim 4, **characterized in that** structures of the first positive-electrode connection points, the first negative-electrode connection points, the second positive-electrode connection points and the second negative-electrode connection points are square structures, side lengths of the square structures are 600-1500 millimeters;
widths of the first positive-electrode connection grid lines, the first negative-electrode connection grid lines, the second positive-electrode connection grid lines and the second negative-electrode connection grid lines are 150-400 millimeters;
widths of the first positive-electrode fine grid portion and the second positive-electrode fine grid portion are 60-200 millimeters; and
widths of the first negative-electrode fine grid portion and the second negative-electrode fine grid portion are 20-60 millimeters.

7. The solar cell sheet according to claim 4, **characterized in that** insulation layers are arranged between the first positive-electrode connection point at a boundary of a solar cell slice and the boundary of the solar cell slice, and between the first negative-electrode connection point at the boundary of the solar cell slice and the boundary of the solar cell slice, sizes of the insulation layers along a direction parallel to the central line of the semiconductor substrate are greater than sizes of insulation layers between two adjacent first positive-electrode connection points and between two adjacent first negative-electrode connection points along the direction parallel to the central line of the semiconductor substrate.

8. The solar cell sheet according to claim 3, **characterized in that** each of the first positive-electrode connection points and the second positive-electrode connection points comprises a central portion and an outer edge portion arranged at an outer side of the central portion;
a structure of the central portion is a square structure, side lengths of the central portion are 600-1200 millimeters;
an inner contour of the outer edge portion and an outer contour of the central portion overlap with each other, an outer contour of the outer edge portion and the inner contour are parallel to each other, and side lengths of the outer contour of the outer edge portion are 800-1600 millimeters.

9. The solar cell sheet according to claim 8, **characterized in that** the central portion is a silver electrode, and the outer edge portion is an aluminum electrode.

10. The solar cell sheet according to claim 1, **characterized in that** the solar cell sheet further comprises:
the semiconductor substrate of the solar cell sheet comprises a silicon substrate, and a semiconductor region arranged at a shadow surface of the silicon substrate and comprising a first semiconductor region and a second semiconductor region.

11. The solar cell sheet according to claim 10, **characterized in that** the solar cell sheet further comprises:
the first semiconductor region is continuously arranged on the silicon substrate in the region corresponding to the first positive-electrode connection points and the second positive-electrode connection points;
the second semiconductor region is continuously arranged on the silicon substrate in the region corresponding to the first negative-electrode connection points and the second negative-electrode connection point.

12. A solar cell slice, **characterized in that** the solar cell slice comprises: a first slice and a second slice that are obtained by cutting the solar cell sheet according to any one of claims 1-11 along the central line of the semiconductor substrate;
the semiconductor substrate comprises the first substrate portion and the second substrate portion that are symmetrically arranged along the central line of the semiconductor substrate;
the first slice comprises the first substrate portion, and the first positive electrode portion and the first negative electrode portion that are arranged in the first substrate portion, the first positive electrode portion and the first negative electrode portion are arranged in parallel;
the second slice comprises the second substrate portion, and the second positive electrode portion and the second negative electrode portion that are arranged in the second substrate portion, the second positive electrode portion and the second negative electrode portion are arranged in parallel; and
in the first slice and the second slice, the extension direction of the first positive electrode portion and the extension direction of the second negative electrode portion coincide, the extension direction of the first negative electrode portion and the extension direction of the second positive electrode portion coincide.

13. A photovoltaic assembly, **characterized in that** the photovoltaic assembly comprises a plurality of solar cell slices according to claim 8 and a plurality of conductive wires;
a first slice and a second slice of the plurality of solar cell slices are separated;
one end of one conductive wire is connected to the first positive electrode portion of the first slice, the other end of the conductive wire is connected to the second negative electrode portion of adjacent second slice; one end of another conductive wire is connected to the first negative electrode portion of the first slice, and the other end of the another conductive wire is connected to the second positive electrode portion of adjacent second slice.

14. The photovoltaic assembly according to claim 13, **characterized in that** the photovoltaic assembly further comprises a connecting part;
the connecting part is arranged between the first slice and the second slice that are adjacent, the connecting part extends along the central line of the semiconductor substrate, and is electrically connected to the conductive wire connecting the first slice and the second slice that are adj acent.
